**Europäisches Patentamt**

**European Patent Office**

**Office européen des brevets**

(11) Veröffentlichungsnummer: **0 218 069**
**A1**

# (12) EUROPÄISCHE PATENTANMELDUNG

(21) Anmeldenummer: **86111736.4**

(22) Anmeldetag: **25.08.86**

(51) Int. Cl.⁴: **B23K 26/00** , **B23K 26/18** , **H01L 21/48**

(30) Priorität: **19.09.85 DE 3533468**

(43) Veröffentlichungstag der Anmeldung:
**15.04.87 Patentblatt 87/16**

(84) Benannte Vertragsstaaten:
**AT CH DE FR GB IT LI**

(71) Anmelder: **Siemens Aktiengesellschaft Berlin und München**
**Wittelsbacherplatz 2**
**D-8000 München 2(DE)**

(72) Erfinder: **Später, Lothar, Dipl.-Ing.**
**Am Klingelberg 21**
**D-6747 Annweiler(DE)**
Erfinder: **Prussas, Herbert, Dipl.-Ing.**
**Mozartring 11**
**D-8069 Reichertshausen(DE)**

(54) **Verfahren zum Verschweissen mittels Laserlicht.**

(57) Die Erfindung betrifft ein Verfahren zum Verschweißen einer metallischen Grundschicht mit einer darauf liegenden dünnen metallischen Abdeckung(4) mittels des Laserlichtes(7), wobei die Abdeckung(4), welche das Laserlicht (7) stark reflektiert, mit einer das Laserlicht (7) weniger stark reflektierenden, nämlich das Laserlicht(7) deutlich absorbierenden Metallhaut(5) bedeckt ist. Falls sowohl die Abdeckung(4) als auch die Grundschicht(3) mit Lötmetall benetzbar ist, wird zuerst die das Laserlicht(5) stark reflektierende Abdeckung(4) mit einer Metallhaut(5) aus einem Lötmetall(5) bedeckt, wonach die Abdeckung(4) mit der Grundschicht(3) mittels des Laserlichtes(7) verschweißt(8) wird.

## FIG 3

## Verfahren zum Verschweißen mittels Laserlicht.

Die Erfindung betrifft eine spezielle Anwendung von Laserlicht, nämlich das im Oberbegriff des Patentanspruchs 1 angegebene spezielle Verfahren zum Verschweißen einer metallischen Grundschicht mit einer darauf liegenden dünnen metallischen Abdeckung mittels Laserlicht. Die Abdeckung kann hierbei selbst z.B. eine elektrische Leitung oder z.B. einen Wärmeableitkörper bilden.

Dieses im Oberbegriff definierte Verfahren ist für sich durch die

* US 4 023 005

vorbekannt. Dort ist beschrieben, daß die metallische Abdekkung aus Kupfer oder Silber oder Gold besteht, wobei die das Laserlicht stark reflecktierende Abdeckung zusätzlich mit einer Metallhaut aus Nickel oder Palladium, welches das Laserlicht relativ stark absorbiert, überzogen ist, und zwar um ein Verschweißen selbst dann mit niedrigem Energieaufwand mittels Laserlicht zu ermöglichen, wenn das Metall der Abdeckung an sich das Laserlicht stark reflektieren würde.

Die Aufgabe der Erfindung ist, die Abdeckung mit einer solchen Metallhaut zu bedecken, die leichter als Nickel oder Palladium anzubrigen ist und aus einem billigen, überall leicht handhabbaren und meistens ohnehin in den betreffenden Werkstütten bereits in großen Mengen zur Verfügung stehenden Metall besteht. Überdies soll die Erfindung ermöglichen, daß zusätzlich, neben dem Verschweißen, noch eine Verlötung der Abdeckung mit der Grundschicht abseits der Verschweißungsstelle erreichbar ist, so daß die Festigkeit der Verbindung zwischen der Abdeckung und der Grundschicht höher ist als bei reiner Verschweißung ohne zusätzliche Verlötung.

Die in den Unteransprüchen genannten zusätzlichen Maßnahmen gestatten, zusätzliche Vorteile zu erreichen. Es gestatten nämlich die Maßnahmen gemäß Patentanspruch

2, Laserlicht besonders stark reflecktierendes reines Cu und/oder stark Cu-haltige Legierungen verschweißen zu können, sowie einen gewissen Korrosionsschutz dieser Cu-haltigen Teile, vor allem auch der Schweißstelle, mittels der Lötmetallhaut erreichen zu können;

3, mit hoher Zuverlässigkeit eine gut haftende Verlötung abseits von der Schweißstelle erreichen zu können und damit mit hoher Zuverlässigkeit eine besonders hohe Festigkeit der Verbindung zwischen der Grundschicht und der Abdeckung erreichen zu können;

4, die Grundschicht für die Verschweißung auf dem -an sich zur direkten Verschweißung mit der Abdeckung ungeeigneten -Träger vorbereiten zu können;

5, besonders wenige verschiedene Materialien für die Befestigung der Abdeckung auf einem lötfähigen, aber nicht verschweißbaren Träger zu benötigen; sowie

6, bei einem konkreten Endprodukt die erfindungsgemäßen Vorteile zur Herstellung desselben zu nutzen.

Die Erfindung wird anhand der in den Figuren gezeigten Beispiele der Erfindung weiter erläutert, wobei die Figuren

1 und 2 eine Draufsicht und eine Seitenansicht eines keramischen Dickschichtschaltungsträgers mit angelötetem Plättchen als Grundschicht, sowie

3 und 4 einen Schnitt durch die zu verschweißende Stelle kurz vor und nach dem Verschweißen zeigen.

Alle Figuren zeigen demnach Details eines erfindungsgemäß hergestellten Produktes, nämlich eines keramischen Schaltungsträgers 1, welches für ein elektronisches Kommunikationssystem, z.B. für ein ISDN-Vermittlungssystem bestimmt ist. Gezeigt ist hierbei in den Figuren das Produkt in seinen verschiedenen Bearbeitungsstufen. Die auf die Grundschicht 3 aufzuschweißende Abdeckung 4 -also Drähte 4, oder ein Bleche 4, oder eine Federlasche 4, oder dgl. -dient z.B. als elektrischer Anschluß 4 und/oder als gut wärmeleitende Wärmeableitung 4.

Keramische Schaltungsträger 1, z.B. mit Schichtschaltungen 2, werden häufig für große Kommunikationssysteme in hermetisch dichte Gehäuse eingebaut. Als Beispiel seien hier Gehäuse für optoelektronische Sende-und Empfangsmodule genannt. Die Schichtschaltungen müssen z.B. mit Anschlußstiften, die von diskreten Bauelementen im Gehäuse, z.B. Infrarotdioden, ausgehen oder die durch das Gehäuse hindurchgeführt worden sind, elektrisch verbunden werden.

Bei entsprechender Lage der Anschlußstifte können derartige elektrische Verbindungen zwar oft mit Hilfe von Geräten zum Anbonden von Drähten hergestellt werden. Liegen die Anschlußstifte infolge des technisch notwendigen Aufbaues des Gehäuses jedoch ungünstig zum Schaltungsträger 1, oder müssen Wärmeleitbändchen 4, z.B. aus Cu, mit verhältnismäßig großem Querschnitt mit dem Schaltungsträger 1 oder mit Bauteilen 2 verbunden werden, dann ist die Anwendung des Drahtbondverfahrens nicht möglich oder sehr aufwendig. Auch das Spaltelektrodenschweißen erfordert dann bestimmte Voraussetzungen, die nicht immer eingehalten werden können. Deshalb werden derartige Verbindungen bisher oft umständlich von Hand gelötet oder geklemmt.

Eine besonders einfach handhabbare Möglichkeit, auf einfache andere Weise besonders feste, sowohl elektrische als auch thermische Verbindungen, z.B. zwischen Schaltungsteilen und Anschlußstiften, mit wenig Laserlichtenergie herzustellen, zeigt die Erfindung.

Wegen der hohen elektrischen und thermischen Leitfähigkeit werden oft Wärmeleitbändchen 4 aus Cu oder aus Cu-Legierungen verwendet. Diese sind aber mit den heute am weitesten verbreiteten ND-YAG-Laser relativ schwer mit ihrer Grundschicht zu verbinden. Außerdem ist die Festigkeit der Verbindung in vielen Fällen nicht ausreichend. Der Grund hierfür ist besonders die Reflexion von Cu im Infrarotbereich, welche, je nach der Oberflächenbeschaffenheit des Cu, sehr unterschiedlich, aber meistens viel zu groß ist.

Die Erfindung löst das Problem, wie eine -z.B. zu elektrischen oder thermischen Zwecken dienende -Abdeckung 4, z.B. ein Wärmeleitbändchen 4, mit der Grundschicht 3 -und damit z.B. mit einem keramischen Träger 1 -selbst in der Massenfertigung verschweißt werden kann, auf eine besondere Weise, welche auch in sehr kleinen Gehäusen bei relativ ungünstigen gegenseitigen Lagen aller solide herzustellenden Schweißstellen mit wenig Aufwand noch gut möglich ist. Ohne viel Aufwand können auf die erfindungsgemäße Weise selbst in engen Gehäusen zwischen beliebig weit entfernten Stellen alle elektrischen und thermischen Verbindungen hergestellt werden; -die Grundschicht kann also nicht nur durch das von den Figuren gezeigte Plättchen 3, sondern z.B. auch durch eine Stelle an einem metallischem Anschlußstift in jenem Gehäuse gebildet sein.

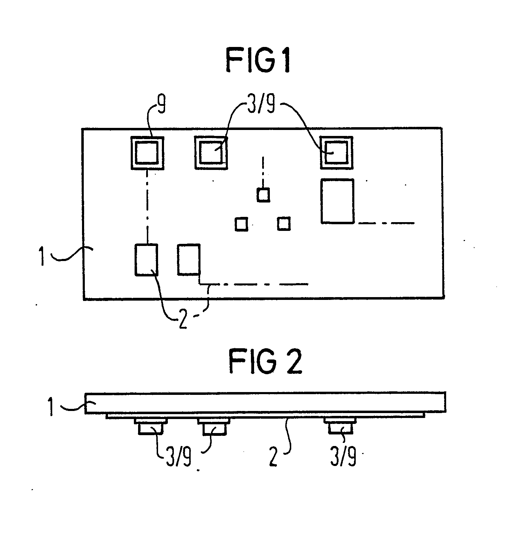

In Fig. 1 und 2 ist also, nur als Beispiel für eine erfindungsgemäße Verschweißung, ein keramischer Dickschicht-Schaltungsträger -gezeigt, auf welchem hauchdünne, z.B. wenige μm dicke, Anschlüsse 2 und Leitungen 2 mittels Siebdruckverfahren aufgedruckt sind und z.B. aus nachträglich ausgehärteten hitzebehandelten Leitpasten bestehen. Solche Anschlüsse 2 können oft nicht als Grundschicht verwendet werden, auf welche eine Abdeckung 4 aufgeschweißt wird, weil nämlich die Anschlüsse 2 dafür teils zu dünn, teils zu empfindlich sind.

Daher wurde, vgl. Fig. 1 bis 4, zunächst eine Metallfolie 3 als schweißfähige Grundschicht 3 zur Massenfertigung von elektrischen und/oder thermischen Anschlüssen 2/3/4 angebracht, wobei anschließend auf diese Grundschicht 3 die elektrisch und/oder thermisch leitende -in Fig. 3 und 4 gezeigte Abdeckung 4 an der Schweißstelle 8 angeschweißt werden. Dazu wird zuerst die mit Lötmetall 5, z.B. mit Sn, benetzbare Abdeckung 4 mit einer Metallhaut 5 aus einem, das Laserlicht 7 möglichst nur noch schwach reflektierenden Lötmetall 5, also z.B. mit dem Sn, bedeckt, wonach die Abdekkung 4 mit der mit diesem Lötmetall 5 ebenfalls benetzbaren Grundschicht 3 mittels des Laserlichtes 7 an der Stelle 8 verschweißt wurde.

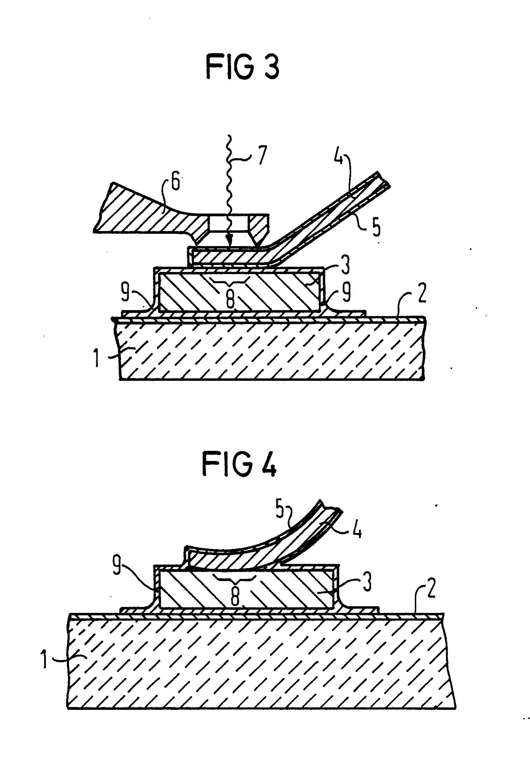

Versuche ergaben, daß eine solche Laser-Schweißverbindung eine besonders hohe Festigkeit und gleichbleibende Qualität aufweist, wenn beide zu verbindenden Teile 3, 4, welche z.B. aus Cu bestehen, vorher jeweils z.B. 2 bis 6 μm dick, z.B. galvanisch oder durch Tauchen, verzinnt werden, vgl. die Sn-Metallhäute 5 und 9 in Fig. 3 und 4. Bei Versuchsverschweißungen einer Grundschicht 3 aus verzinntem Cu mit einer Abdeckung 4 aus verzinnter CuCoBe-Legierung wurde z.B. mit 30 % weniger Lichtenergie 7 etwa die doppelte Festigkeit erzielt, verglichen mit einer Verschweißung ohne jegliche Verzinnung der Teile 3 und 4 unter im übrigen sehr günstigen Verhältnissen. Die erhöhte Festigkeit der erfindungsgemäß hergestellten Verschweißung resultiert auch daraus, daß auch das Sn beim Verschweißen rings um die Schweißstelle 8 schmilzt und somit eine zusätzliche Lötverbindung entsteht. Außer der energieärmeren besseren Verschweißung ergibt sich durch die Sn-Oberfläche auch ein guter Schutz gegen eine Oxidbildung an der Cu-Oberfläche und auf der CuCoBe-Oberfläche. Dadurch können die Teile 3,4 entsprechend länger an Luft gelagert und transportiert werden.

Um Laserschweißungen auf Schichtschaltungen mit μm-dicken Schichten 2 trotz der geringen Schichtdicke zu ermöglichen und um die genannten erfindungsgemäß erreichbaren Vorteile für die thermischen und/oder elektrischen Verbindung der Teile 3, 4 zu nutzen, kann der Schaltungsträger 1 entsprechend Fig.1 an der gewünschten Stelle 2 mit einem verzinnten Plättchen 3 aus Cu 3 oder aus einer Cu-Legierung 3 hybridiert, nämlich verlötet werden, wobei dieses Cu-Plättchen 3 beispielsweise 200 μm dick ist, also eine wesentlich größere Dicke besitzt als die z.B. 0,2...35 μm dicken Schichten 2. Dann wird die Abdeckung 4, z.B. ein Wärmeleitbändchen 4, welches mit einer lötfähigen (Sn-) Metallhaut 5 versehen ist, auf das Plättchen 3 aufgelegt, dann mit Hilfe eines, z.B. ringförmigen, Niederhalters/Drückkörpers 6 an das Plättchen 3 angedrückt, sowie danach durch einen auf der Achse einfallenden Laserschuß 7 punktuell so stark erhitzt, daß entsprechend Fig. 4 die Unterseite der Abdeckung 4 an der Stelle 8 mit dem Plättchen 3 verschweißt ist. Dabei verschmelzen auch die Verzinnungen 5, 9 der Abdeckung 4 und des Plättchens 3 miteinander und bilden eine zusammenhängende Schutzschicht 5/9 rings um die Schweißstelle 8 herum, welche die Festigkeit der Verschweißung noch weiter erhöht.

Nachdem die verschweißte Stelle 8 erstarrt ist, aber bevor das aufgeschmolzene Lötmetall 5 erstarrt ist, wird der Niederhalter 6 abgehoben, damit das Lötmetall 5 auch an der Berührungsfläche zwischen dem Niederhalter 6 und der Abdeckung 4 gut verläuft und damit die Verlötung zwischen der Abdeckung 4 und dem Plättchen 3 beim Abheben des Niederhalters 6 nicht mehr aufgerissen wird.

Besonders günstig kann es oft sein, die Grundschicht 3 vor dem Verschweißen mit der Abdeckung 4 auf eine für Lötmetall haftfähige Fläche 2 des Trägers 1 zu löten, wobei diese Fläche 2 selbst z.B. aus einer mittels Siebdruck gedruckter Lötpaste 2 bestehen kann. Ein solche Herstellungstechnik ist in sich sehr einheitlich, sie benötigt nämlich besonders wenig Arten von Materialen und besonders wenig Arten von Techniken, um die gewünschten elektrischen und/oder thermischen Verbindungen 3/4 herzustellen.

## Ansprüche

1. Verfahren zum Verschweißen einer metallischen Grundschicht (3) mit einer darauf liegenden dünnen metallischen Abdeckung(4) mittels Laserlicht(7), wobei die Abdeckung (4), welche das Laserlicht(7) stark reflektiert, mit einer das Laserlicht(7) weniger stark reflektierenden, nämlich das Laserlicht(7) deutlich absorbierenden Metallhaut(5) bedeckt ist,

-z.B. zum Verschweißen von Metallbändchen(4) als Abdeckung(4) mit einer, einen keramischen Dickschicht-Schaltungsträger(1) bedeckenden Metallfolie(3) als Grundschicht(3), zur Massenfertigung der elektrischen und/oder thermischen Anschlüsse der Dickschichtschaltung eines elektronisches Kommunikationssystemes, z.B. eines elecktronisches Fernsprech-Vermittlungssystemes,

**dadurch gekennzeichnet, daß**

-falls sowohl die Abdeckung(4) als auch die Grundschicht (3) mit Lötmetall benetzbar ist, zuerst zumindest die das Laserlicht(7) stark reflektierende Abdeckung(4) mit einer Metallhaut (5) aus einem Lötmetall(5) bedeckt wird, und

-danach die Abdeckung(4) mit der Grundschnicht-(3) mittels des Laserlichtes(7) verschweißt(8) wird.

2. Verfahren nach Patentanspruch 1,

**dadurch gekennzeichnet, daß**

-zuerst die in hohem Maße Cu enthaltende Abdeckung(4) mit der Metallhaut(5) aus Lötmetall-(5) bedeckt wird, und

-danach die Abdeckung(4) mit der in hohem Maße Cu enthaltenden, ebenfalls mit einer Metallhaut(9) aus Lötmetall(9) bedeckten Grundschicht(3) mittels des Laserlichtes(7) verschweißt(8) wird.

3. Verfahren nach Patentanspruch 1 oder 2,

**dadurch gekennzeichnet, daß**

-beim Verschweißen die Abdeckung(5) mittels eines Drückkörpers(6) auf die Grundschicht(3) gedrückt wird, und

-der Drückkörper(6) nach dem Erstarren der verschweißten Stelle(8), aber noch vor dem Erstarren des Lötmetalles (5) der drückkörpernahen Metallhaut(5) der Abdeckung(4) wieder von der Abdeckung(5) abgehoben wird.

4. Verfahren nach Patentanspruch 2 oder 3,

**dadurch gekennzeichnet, daß**

-die Grundschicht(3) ein Plättchen(3) bildet, welches als Kontaktflecken(3) auf einem keramischen Schaltungsträger(1) eines elektronischen Vermittlungssystemes angebracht wurde.

5. Verfahren nach Patentanspruch 2, 3 oder 4,

**dadurch gekennzeichnet, daß**

-die Grundschicht(3), vor dem Verschweißen mit der Abdeckung(4), auf einer für Lötmetall haftfähigen Fläche (2) eines Trägers(1) gelötet wurde.

6. Produkt, hergestellt durch ein Verfahren nach einem der Patentansprüche 1 bis 5.

## FIG 1

9

3/9

1

2

## FIG 2

1

3/9   2   3/9

# FIG 3

# FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X,D | US-A-4 023 005 (S.R. BOLIN)<br>* Das ganze Dokument *<br>--- | 1,2,6 | B 23 K 26/00<br>B 23 K 26/18<br>H 01 L 21/48 |
| A | PATENTS ABSTRACTS OF JAPAN, Band 7, Nr. 215 (M-244)[1360], 22. September 1983; & JP-A-58 110 172 (TOKYO SHIBAURA DENKI K.K.) 30-06-1983<br>* Das ganze Dokument *<br>--- | 1-3 | |
| A | FEINWERKTECHNIK UND MESSTECHNIK, Band 90, Nr. 5, Juli/August 1982, Seiten 239-241, München, DE; H. WEISSMANTEL: "Das Schweissen von Kupfer mit dem Laserstrahl"<br>* Kapitel 1,2 *<br>--- | 1,2 | |
| A | WO-A-8 402 867 (FORD MOTOR CO.)<br>* Seite 6, Zeile 23 - Seite 11, Zeile 5; Abbildung 3 *<br>--- | 1-6 | RECHERCHIERTE SACHGEBIETE (Int. Cl.4)<br><br>B 23 K<br>H 01 L |
| A | LASER UND ELEKTRO-OPTIK, Band 7, Nr. 3, September 1975, Seiten 14-18, Stuttgart, DE; "Laser in der Praxis, Aufgabe: Automatisches Laserschweissen von Kontakten für Telefonmikrorelais"<br>* Das ganze Dokument *<br>----- | 1,4 | |

Der vorliegende Recherchenbericht wurde für alle Patentansprüche erstellt.

| Recherchenort | Abschlußdatum der Recherche | Prüfer |
|---|---|---|
| DEN HAAG | 15-12-1986 | ARAN D.D. |